# EUROPÄISCHE PATENTANMELDUNG

(11) **EP 2 003 698 A2**
(43) Veröffentlichungstag der Anmeldung: **17.12.2008**
(21) Anmeldenummer: 08010672.7
(22) Anmeldetag: 12.06.2008
(51) Int. Cl.: H01L 31/0224, H05K 3/04

(54) **Heißprägen von Leiterbahnen auf Photovoltaik-Silizium-Wafer**

(30) Priorität: 14.06.2007 DE 102007027998
(71) Anmelder: Leonhard Kurz Stiftung & Co. KG, 90763 Fürth (DE)
(72) Erfinder: Schindler, Ulrich, Dr., 90762 Fürth/Bayern (DE)
(74) Vertreter: LOUIS, PÖHLAU, LOHRENTZ

(57) **Zusammenfassung**

Es wird ein Verfahren zur Erzeugung von Leiterbahnen (22, 322, 422, 522) auf einem für photovoltaische Zellen vorgesehenen Silizium-Wafer (1) beschrieben. Eine elektrisch leitfähige Transferschicht (22) wird von einer Prägefolie (2), insbesondere einer Heißprägefolie, vollständig oder bereichsweise auf die Oberfläche des Silizium-Wafers (1) übertragen.

## Beschreibung

Die Erfindung betrifft ein Verfahren zur Erzeugung von Leiterbahnen auf einem Photovoltaik-Silizium-Wafer sowie eine Prägefolie zur Durchführung des Verfahrens.

Es ist bekannt, bei der Herstellung von photovoltaischen Zellen auf der Basis eines Silizium-Wafers die abschließende zweite Elektrode als Leiterbahn mittels Flachbettsiebdruck auf den Silizium-Wafer aufzubringen und sodann zu sintern.

Flachbettsiebdruck ist ein zeitaufwendiges Verfahren und für eine kontinuierliche Fertigung und eine kostengünstige Massenproduktion schlecht geeignet. Insbesondere können beim Flachbettsiebdruck die Kanten des Druckbilds während des Druckens und besonders beim Druck abrasiver Medien ausbrechen. Dies kann Ungleichmäßigkeiten im Druckbild der Leiterbahnen der Elektroden und damit ungleichmäßige elektrische Eigenschaften der Elektroden zur Folge haben.

In der DE 689 26 361 T2 sind ein Verfahren und eine Vorrichtung zum Druck- und Wärmekleben eines dünnen Films auf eine Basisplatte beschrieben. Bei der Basisplatte kann es sich beispielsweise um ein elektronisches Schaltkreis-Substrat aus Silizium, Gallium-Arsenid oder ähnlichem handeln. Zur Vermeidung von Hohlräumen zwischen dem Film und der Basisplatte ist das Anlegen von Vakuum vorgesehen.

Aufgabe der vorliegenden Erfindung ist es, ein verbessertes Verfahren zum Aufbringen der Leiterbahnen auf den Silizium-Wafer anzugeben.

Erfindungsgemäß wird diese Aufgabe mit dem Gegenstand des Anspruchs 1 gelöst. Es wird ein Verfahren zur Erzeugung von Leiterbahnen auf einem für photovoltaische Zellen vorgesehenen Silizium-Wafer vorgeschlagen, wobei vorgesehen ist, dass eine elektrisch leitfähige Transferschicht von einer Prägefolie, insbesondere einer Heißprägefolie, vollständig oder bereichsweise auf die Oberfläche des Silizium-Wafers übertragen wird.

Das erfindungsgemäße Verfahren sieht also vor, die Ausbildung der Leiterbahnen im Wesentlichen in einen vorgelagerten Fertigungsschritt zu verlagern, nämlich in die Fertigung von Prägefolien, insbesondere Heißprägefolien. Die Herstellung von Heißprägefolien erfüllt höchste Ansprüche an die Passergenauigkeit der Leiterbahnen, wobei es sich bei den Leiterbahnen sowohl um Leiterbahnen im herkömmlichen Sinne als auch um Elektroden oder sonstige elektrisch leitenden Bereiche handeln kann.

Heißprägefolien werden vorzugsweise in einem Rolle-zu-Rolle-Verfahren hergestellt. Dabei können wichtige funktionelle Parameter der Transferschicht, wie Materialzusammensetzung, Dicke, Struktur und Geometrie eingestellt werden, wobei die erzielbaren Toleranzen im Bereich von Mikrometern bis zu Nanometern liegen. Beim Heißprägen sind nur wenige Parameter, wie Temperatur, Anpressdruck und Verweilzeit (Prägezeit, Geschwindigkeit), zu kontrollieren, um eine gleichbleibende Qualität der übertragenen Schichten zu erhalten. Demgegenüber ist der Flachbettsiebdruck technologisch viel aufwendiger und schlechter kontrollierbar, da, wie bereits erwähnt, Kanten ausbrechen oder Lösungsmittel aus dem Druckmedium während des Druckvorgangs entweichen können.

Die Prägefolie weist vorzugsweise eine Trägerschicht und eine Transferlage auf, die mindestens eine Transferschicht und vorzugsweise eine Kleberschicht aufweist, die auf der der Trägerschicht abgewandten Seite der Transferlage angeordnet ist. Zwischen Transferlage und Trägerschicht ist vorzugsweise eine Ablöseschicht angeordnet. Die Transferlage wird mit der der Trägerschicht abgewandten Seite auf das Zielsubstrat appliziert. Die der Trägerschicht abgewandte Oberfläche der Transferlage ist hierbei so ausgestaltet, dass sie, vorzugsweise unter Einwirkung von Hitze und/oder Druck, an dem Zielsubstrat anhaftet. Diese Oberfläche wird so vorzugsweise von der Oberfläche einer Grundierungsschicht gebildet, die auf der der Trägerschicht abgewandten Seite der Transferschicht aufgebracht ist. Bei der Applizierung wird die Prägefolie gegen das Zielsubstrat gepresst, hierbei ein Anhaften der Transferlage an dem Substrat, beispielsweise durch Hitze und/oder Druck bewirkt, und sodann die Trägerschicht von der Transferlage abgezogen.

Die Heißprägefolie weist mindestens eine Trägerschicht und eine Transferschicht auf. Beim Heißprägen wird ein beheizter Prägestempel mit erhabenen Bereichen in Druckkontakt mit der zwischen dem Prägestempel und dem zu beprägenden Substrat, hier dem Silizium-Wafer, angeordneten Heißprägefolie gebracht, wobei die Trägerschicht dem Prägestempel zugewandt ist. Unter den erhabenen Bereichen angeordnete Bereiche der Transferschicht werden durch Druck und Wärme auf das Substrat übertragen, wobei in der Transferschicht Bruchlinien ausgebildet werden, die den Kanten der erhabenen Bereiche folgen. In den Bereichen, in denen der Prägestempel in Kontakt mit der Heißprägefolie kommt, wird durch die Hitze und den Druck bewirkt, dass die Haftkraft zwischen Transferlage und zu beprägendem Substrat größer als zwischen Transferlage und Trägerschicht ist, beispielsweise indem eine zwischen Trägerschicht und Transferlage angeordnete Ablöseschicht erweicht und eine zwischen Transferschicht und zu beprägendem Substrat angeordnete Kleberschicht aktiviert wird. Der Prägestempel kann also durch die Ausbildung seiner Prägeoberfläche die geometrische Struktur der übertragenen Transferschicht bestimmen. Er kann so, wie weiter unten näher beschrieben, auch als Strukturstempel bezeichnet werden. Nach dem Abziehen des Prägestempels verbleiben die von den erhitzten erhabenen Bereichen des Prägestempels übertragenen Bereiche der Transferschicht auf dem beprägten Substrat. Die nicht erhitzten Bereiche der Transferschicht verbleiben auf der Trägerfolie und werden mit dieser abgezogen. Wenngleich das Heißprägen keine strukturierte Transferschicht erfordert, so kann doch auch die Übertragung einer strukturierten oder vorstrukturierten Transferschicht vorgesehen sein.

Die Trägerschicht der Prägefolie ist vorzugsweise eine Trägerfolie aus einem Kunststoff, beispielsweise Polyester, und weist vorzugsweise eine Dicke von weniger als 200 µm, weiter bevorzugt von 12 µm bis 50 µm auf. Zwischen der Trägerschicht und der Transferschicht ist vorzugsweise eine Ablöseschicht angeordnet. Die Ablöseschicht besitzt vorzugsweise eine Dicke kleiner 2 µm und enthält Wachskomponenten, die beim Erhitzen ihre Haftkraft einbüßen und so die Trennung der Transferschicht von der Trägerfolie erleichtern. Weiter kann auf der Transferschicht eine Grundierungsschicht angeordnet sein, die beim Prägen mit übertragen wird und die beispielsweise die Haftung der Transferschicht auf dem beprägten Substrat unterstützt. Die Grundierungsschicht kann beispielsweise als eine Kleberschicht, vorzugsweise eine thermisch aktivierbare Kleberschicht ausgebildet sein. Die Kleberschicht kann eine Dicke kleiner als 10 µm aufweisen, vorzugsweise im Bereich von 0,5 bis 2 µm. Die Kleberschicht kann aber auch aus einem Kaltkleber oder aus einem UV-härtbaren Kleber ausgebildet sein. Es ist aber auch möglich, dass die Transferschicht selbst Kompenten aufweist, die die Haftung der Transferschicht auf dem beprägten Substrat vermitteln.

Weitere vorteilhafte Ausbildungen sind in den Unteransprüchen bezeichnet.

Es kann vorgesehen sein, dass eine Prägefolie mit einer geometrisch strukturierten elektrisch leitfähigen Transferschicht verwendet wird.

Es kann aber auch vorgesehen sein, dass eine Prägefolie mit einer vollflächigen elektrisch leitfähigen Transferschicht verwendet wird, und dass die Transferschicht bei der Übertragung auf den Silizium-Wafer durch einen Strukturstempel strukturiert wird. Dabei bestimmt die Oberflächenstruktur des Strukturstempels die Umrisse der übertragenen Transferschicht. Die nicht benötigten Bereiche der Transferschicht verbleiben nach dem Prägen auf der Prägefolie und werden verworfen.

Es ist möglich, dass die Transferschicht durch Hubprägung übertragen wird.

Es ist weiter möglich, dass die Transferschicht durch Abrollprägung übertragen wird.

Es ist auch möglich, dass die Leiterbahnen in mehr als einem Prägeschritt erzeugt werden. Es kann also vorgesehen sein, die Leiterbahnen abschnittsweise zu prägen.

Es kann vorgesehen sein, dass nacheinander Transferschichten aus unterschiedlichem Material und/oder mit unterschiedlicher elektrischer Leitfähigkeit und/oder Dicke und/oder geometrischer Struktur und/oder mit unterschiedlichem Querschnittsprofil übertragen werden. Auf diese Weise können die Eigenschaften der Leiterbahnen in vielfältiger Weise variiert werden. Insbesondere ist es möglich, sie bereichsweise zu variieren, beispielsweise Bereiche als Elektroden und Bereiche als Leiterbahnen oder dergleichen auszubilden. Die Leiterbahnen können beispielsweise Elektroden miteinander verbinden und auf diese Weise Serien- und/oder Parallelschaltungen einzelner photovoltaischer Zellen ausbilden.

Es ist so möglich, dass durch Übertragen von zwei oder mehr Transferschichten in der Leiterbahn ein Leitfähigkeitsgradient erzeugt wird, beispielsweise wenn die einzelnen Tranferschichten unterschiedliche Leitfähigkeiten aufweisen.

Es kann vorgesehen sein, dass die geometrische Struktur und/oder eine Leitfähigkeitsstruktur der Leiterbahn durch die Ausbildung des Prägestempels und/oder der Prägefolie eingestellt wird bzw. werden, wie weiter oben beschrieben. Es kann also vorgesehen sein, Leiterbahnbereiche von einer Prägefolie mit strukturierter Transferschicht zu übertragen und/oder Leiterbahnbereiche mittels eines Strukturstempels von einer Prägefolie mit vollflächiger Transferschicht zu übertragen.

Es ist möglich, beide Methoden miteinander zu kombinieren. Es kann beispielsweise eine Prägefolie vorgesehen sein, deren Transferschicht sowohl strukturierte als auch unstrukturierte Bereiche aufweist und weiter ein Prägestempel, der bereichsweise als Strukturstempel ausgebildet ist.

Weiter kann vorgesehen sein, dass durch Übertragen von zwei oder mehr Transferschichten die Haftung der Leiterbahn lokal variiert wird. Die unterschiedliche Haftung kann durch unterschiedliche Strukturierung der Transferschicht und/oder unterschiedliche Zusammensetzung der Transferschicht und/oder durch eine oder mehrere Schichten der Prägefolie hervorgerufen sein. Es können beispielsweise Schichten vorgesehen sein, die als Kleberschicht oder als Trennschicht wirken oder die infolge eines Sinterungsprozesses eine unterschiedliche Haftwirkung hervorrufen.

In einer weiteren vorteilhaften Ausbildung kann vorgesehen sein, dass Prägefolien mit Trägerschichten verwendet werden, die sich in mindestens einer Eigenschaft voneinander unterscheiden, beispielsweise Dicke und/oder Flexibilität und/oder stoffliche Zusammensetzung.

Es ist weiter möglich, dass eine Prägefolie verwendet wird, die keine Ablöseschicht aufweist.

Es ist auch möglich, dass eine Prägefolie verwendet wird, die keine Grundierungsschicht aufweist.

Mit dem erfindungsgemäßen Verfahren ist es möglich, dass mehrere Silizium-Wafer in einem Prägevorgang kontinuierlich beprägt werden.

Es ist aber auch möglich, dass mehrere Silizium-Wafer in einem Prägevorgang diskontinuierlich beprägt werden.

Vorteilhafterweise kann vorgesehen sein, dass als Transferschicht eine Metallschicht verwendet wird.

Es können weitere Transferschichten übertragen werden, die in Verbindung mit der als Elektrodenschicht vorgesehenen Transferschicht besondere Effekte generieren können.

Beispielsweise kann vorgesehen sein, dass es sich bei den weiteren Schichten um elektrochrome und/oder thermochrome Schichten handelt oder um Schichten, welche die Wellenlänge des einfallenden Lichtes so zu transformieren vermögen, dass ein breiteres Lichtspektrum ausnutzbar ist und/oder thermische Überhitzung des Silizium-Wafers vermieden wird.

Weiter ist es möglich, dass nach dem Übertragen der Transferschicht bzw. der Transferschichten ein Sinterungsprozess ausgeführt wird. Mit dem Sinterungsprozess kann beispielsweise die Haftung der übertragenen Transferschicht auf dem Silizium-Wafer verbessert werden und/oder es können organische Bestandteile aus der übertragenen Transferschicht ausgetrieben werden. Mit den Parametern Sintertemperatur und Sinterdauer kann beispielsweise die gegenseitige Diffusion der aneinandergrenzenden Materialien beeinflusst werden, so dass eine Grenzschicht ausgebildet wird, in der Transferschicht und Silizium-Wafer stoffschlüssig miteinander verbunden sind.

Es ist möglich, dass zwischen zwei aufeinander folgenden Prägevorgängen ein Sinterungsprozess ausgeführt wird. Es ist aber auch möglich, dass weniger Sinterungsprozesse vorgesehen sind, beispielsweise eine Sinterung nach Abprägen der ersten Transferschichtung und eine Abschlusssinterung.

Es kann vorgesehen sein, dass die zwei oder mehrere Sinterungsprozesse bei gleicher Temperatur ausgeführt werden.

Es kann aber auch vorgesehen sein, dass die zwei oder mehreren Sinterungsprozesse bei unterschiedlicher Temperatur und/oder Verweilzeit ausgeführt werden.

Es kann vorgesehen sein, dass die Sinterungstemperatur im Bereich von 300 °C bis 800 °C eingestellt wird.

Weiter kann vorgesehen sein, dass die Sinterungstemperatur im Bereich von 450 °C bis 550 °C eingestellt wird.

Wie Versuche gezeigt haben, kann vorteilhafterweise vorgesehen sein, dass die Sintertemperatur auf ca. 500 °C eingestellt wird. Die Sinterzeit kann zwischen ca. 10 Minuten und ca. 30 Minuten betragen, wobei die Sintertemperatur für etwa 5 Minuten gehalten wird.
Es kann aber auch nach einem Sinterungsprozess bzw. nach einem Temperaturbehandlungsprozess, wie beispielsweise Tempern, ein Kühlschritt vorgesehen sein.

Weiter kann vorgesehen sein, dass der Sinterungsprozess und/oder der Temperaturbehandlungsprozess in einer von Luft verschiedenen Atmosphäre durchgeführt wird, beispielsweise in einer Schutzgasatmosphäre, wie Stickstoff oder Argon.

Es können auch zwischen den einen oder mehreren Sinterungsprozessen und/oder Temperaturbehandlungsprozessen eine oder mehrere Reinigungsphasen vorgesehen sein.

Es kann vorgesehen sein, den Silizium-Wafer in den Reinigungsphasen mit Gasen und/oder Flüssigkeiten zu beaufschlagen.

Die Temperaturregime und/oder die Verweilzeitregime in den Reinigungspasen oder in der Reinigungsphase können variiert werden, um einen optimalen Reinigungseffekt zu erzielen.

Es kann weiter vorgesehen sein, dass auch nach einem oder mehreren Prägevorgängen Reinigungsphasen durchlaufen werden.

Es ist auch möglich, dass nach einem oder mehreren Prägevorgängen chemische Prozessschritte eingefügt werden, die beispielsweise Schichten partiell oder vollständig anlösen können, wobei zahlreiche Prozessparameter einstellbar sind, wie beispielsweise die chemische Zusammensetzung der mit dem Silizium-Wafer in Kontakt gebrachten Stoffe, die Verweilzeit, die Prozesstemperatur und der Prozessdruck.

Weitere optionale Ausbildungen des erfindungsgemäßen Verfahrens sind auf die übertragbaren Transferschichten gerichtet.

Es kann vorgesehen sein, dass nacheinander unterschiedliche Materialien übertragen werden. So ist es möglich, dass anorganische Schichten, zum Beispiel ITO übertragen werden oder auch organische Schichten übertragen werden, wobei die organischen Schichten entweder als Funktionsschichten oder als chemische Reagenzien einsetzbar sind.

Als ein weiterer Verfahrensschritt kann vorgesehen sein, dass eine Transferschicht als Abschlussschicht aufgebracht wird, die eine Individualisierung des Silizium-Wafers aufweist, beispielsweise ein Hologramm. Auf diese Weise kann beispielsweise Produktfälschungen vorgebeugt werden oder die Herstellungscharge oder dergleichen festgehalten werden.

Es kann auch vorgesehen sein, abschließend eine oder mehrere Schutzschichten zum Schutz der durch Heißprägen übertragenen Elektrodenschicht bzw. Elektrodenschichten aufzuprägen. Die Schutzschicht kann beispielsweise eine Farb- oder Dekorschicht und/oder eine funktionelle Schicht sein, wobei ein Temperaturprozess angeschlossen werden kann, um beispielsweise Zwischenschichthaftungen zu verbessern.

Weiter kann vorgesehen sein, abschließend eine Antihaftschicht auf die durch Heißprägen übertragenen Elektrodenschicht bzw. Elektrodenschichten aufzuprägen.

Die Übertragung der vorgenannten abschließenden Schichten kann analog zu den anderen Schichten vollflächig oder partiell vorgesehen sein.

Abschließend aufgebrachte Schichten können auch vollflächig oder partiell eingefärbt sein. Die Einfärbung kann beispielsweise als Dekoration oder als Alterungsindikator vorgesehen sein.
Es können auch Abschlussschichten vorgesehen sein, die vollflächig oder partiell mit einem Indikator versehen sind, der beispielsweise über Alterung und/oder Einsatzfähigkeit Auskunft gibt und der nicht auf einem Farbeffekt beruht. Beispielsweise kann der Indikator als ein RFID-Tag ausgebildet sein.

Es ist vorgesehen, dass nach dem Aufbringen der Abschlussschicht kein Temperaturprozess durchgeführt wird oder ein oder mehrere Temperaturprozesse bei niedrigen Temperaturen, um beispielsweise Zwischenschicht-Haftungseigenschaften zu verbessern.

Weitere vorteilhafte Ausbildungen sind auf die Prägefolie gerichtet.
Zur Durchführung des Verfahrens ist eine Prägefolie, insbesondere Heißprägefolie, vorgesehen, die eine strukturierte elektrisch leitende Transferschicht aufweist. Der Begriff "Strukturierung" ist hierbei im weitesten Sinne verstanden, so dass auch eine vollflächige Transferschicht gleicher Dicke mit einer Strukturierung ausgebildet sein kann, beispielsweise mit einer Oberflächenstrukturierung.

Es kann vorgesehen sein, dass die Transferschicht geometrisch strukturiert ist. Eine solche Transferschicht kann als Muster von Leiterbahnen ausgebildet sein, d.h. sie enthält mindestens einen Bereich, in dem das Material der Transferschicht entfernt ist.

Es kann vorgesehen sein, dass die Transferschicht durch einen Druckprozess und/oder einen Bedampfungsprozess mit einer Maske mit anschließendem Strukturierungsprozess (z.B. Ätzen) strukturiert ist.

Es kann auch vorgesehen sein, dass die Prägefolie segmentiert ist, d.h. Segmente aufweist, die sich hinsichtlich ihrer Schichten und/oder ihrer Schichtfolge unterscheiden können.

Vorzugsweise kann vorgesehen sein, dass die Transferschicht als Metallschicht ausgebildet ist. Die Metallschicht kann sowohl aus einem einzelnen Metall als auch aus einer Metalllegierung ausgebildet sein.

Es ist möglich, dass die Metallschicht aus Metallpartikeln gebildet ist. Bei den Metallpartikeln kann es sich auch um sehr kleine Partikel im Nanometerbereich handeln, die in der Fachliteratur auch als Cluster bezeichnet werden. Derartige Cluster können Materialeigenschaften aufweisen, die sich grundlegend von den Materialeigenschaften größerer Partikel unterscheiden.

Es ist möglich, dass die Metallpartikel annähernd gleiche Abmessungen aufweisen, wobei die Verteilung der Abmessungen beispielsweise einer Glockenkurve folgen kann, d.h. einer Gaußschen Verteilung. Es kann somit beispielsweise nach dem Sinterungsprozess davon ausgegangen werden, dass gleich große Bereiche unterschiedlicher Metalle in der Elektrode vorliegen, wenn eine Mischung von zwei oder mehr Metallen bzw. Metalllegierungen übertragen wurde.

Es ist aber auch möglich, dass die Metallpartikel unterschiedliche Abmessungen aufweisen. Es kann somit beispielsweise nach dem Sinterungsprozess davon ausgegangen werden, dass unterschiedlich große Bereiche unterschiedlicher Metalle in der Elektrode vorliegen, wenn ein Gemisch aus wenigstens zwei Metallen bzw. Metalllegierungen übertragen wurde.

Weiter kann vorgesehen sein, dass die Konzentration der Metallpartikel in der Metallschicht konstant ist.

Es kann aber auch vorgesehen sein, dass die Konzentration der Metallpartikel in der Metallschicht nicht konstant ist.

Wenngleich die Verwendung einer metallischen Transferschicht bevorzugt ist, so kann doch anstelle von "Metall" bzw. "Metallpartikel" auch nichtmetallisches leitfähiges Material vorgesehen sein, beispielsweise sogenannte "Nanotubes" aus Kohlenstoff oder leitfähiger Kunststoff. Ist dies der Fall, sind die Temperaturen und die sonstigen Prozessbedingungen nachfolgender Schritte entsprechend anzupassen.

Es ist möglich, dass die Prägefolie mehrere Ablöseschichten aufweist.

Weiter kann vorgesehen sein, dass die Prägefolie mehrere Grundierungsschichten aufweist.

Es ist auch möglich, dass die Ablöseschichten und/oder die Grundierungsschichten nicht vollflächig ausgebildet sind. Auf diese Weise können beispielsweise je nach Prägebedingungen unterschiedliche Bereiche der Transferschicht übertragen werden.

In Anwendung des vorstehend beschriebenen Verfahrens bzw. der Prägefolie kann eine photovoltaische Zelle auf der Basis eines Silizium-Wafers, auf dessen Oberfläche eine elektrisch leitfähige strukturierte Transferschicht einer Prägefolie, vorgesehen sein. Es handelt sich also um eine photovoltaische Zelle, die auf einem Silizium-Wafer aufgebaut ist und deren oberste elektrisch leitfähige Schicht aus der besagten Transferschicht gebildet ist.

Die Erfindung wird nun anhand der Figuren näher erläutert. Es zeigen:
- Fig. 1 a, b: Schematische Schnittdarstellungen von Fertigungsschritten eines ersten Ausführungsbeispiels;
- Fig. 2a, b: schematische Schnittdarstellungen von Fertigungsschritten eines zweiten Ausführungsbeispiels;
- Fig. 3: eine schematische Schnittdarstellung eines dritten Ausführungsbeispiels;
- Fig. 4: eine schematische Schnittdarstellung eines vierten Ausführungsbeispiels;
- Fig. 5: eine schematische Draufsicht eines fünften Ausführungsbeispiels;
- Fig. 6: eine schematische Schnittdarstellung eines sechsten Ausführungsbeispiels;
- Fig. 7a, b: schematische Schnittdarstellungen von Fertigungsschritten eines siebten Ausführungsbeispiels.

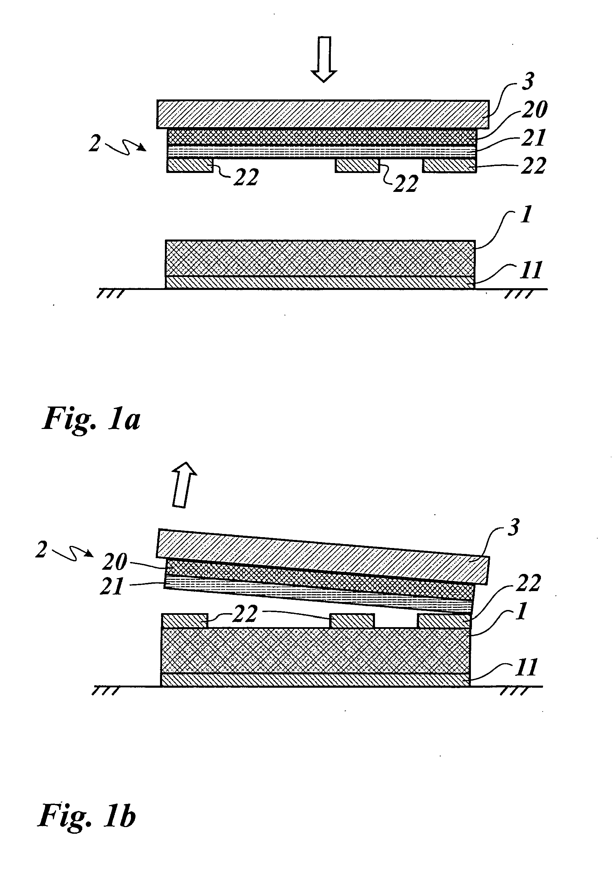

Die Fig. 1 zeigt einen dotierten und behandelten Silizium-Wafer 1 mit einer rückseitigen ersten Elektrodenschicht 11, der in bekannter Weise durch Dotierung zum Aufbau einer photovoltaischen Zelle geeignet ist.

Eine Heißprägefolie 2 ist aus einer Trägerfolie 20, einer Ablöseschicht 21 und einer elektrisch leitfähigen Transferschicht 22 gebildet, wobei die Heißprägefolie auf einem beheizten Prägestempel 3 aufgenommen ist.

Dabei ist die Rückseite der Trägerfolie 20 der Vorderseite des Prägestempels 3 zugewandt. Die Vorderseite der Heißprägefolie 2, die zugleich die Vorderseite der Transferschicht 22 bildet, ist der Oberseite des Silizium-Wafers 1 zugewandt und wird während des Prägeprozesses mit dieser in Kontakt gebracht. Dadurch wird die Transferschicht 22 auf die Oberseite des Silizium-Wafers 1 übertragen, wie in Fig. 1b dargestellt, und bildet dort Leiterbahnen aus, die als Elektrodenbereiche und/oder Kontaktbereiche und/oder sonstige elektrisch leitfähige Bereiche nutzbar sind.

Nach der Übertragung der Transferschicht 22 wird der Prägestempel 3 abgehoben, wobei die Ablöseschicht 21 die Trennung der Transferschicht 22 von der Heißprägefolie 2 unterstützt.

Bei der Transferschicht 22 kann es sich um eine teilmetallische Schicht handeln, beispielsweise aus Gold, Silber, Aluminium, Kupfer oder einer Legierung aus diesen Metallen in einer organischen Matrix, die als Kleber zur Haftung der metallischen Komponente vorgesehen ist. Sie kann bei der Herstellung der Heißprägefolie 2 beliebig strukturiert werden, so dass beispielsweise Leiterbahnen bzw. Elektrodenbereiche zur Ausbildung einer zweiten Elektrodenschicht auf dem Silizium-Wafer 1 abgeformt werden können. Es kann sich aber auch um eine elektrisch leitfähige organische Schicht handeln. Die Transferschicht 22 kann in bekannter Weise durch Sputtern, Aufdampfen oder Aufdrucken auf die Heißprägefolie aufgebracht sein. Wenn Sputtern oder Aufdampfen vorgesehen ist, kann sodann das Aufbringen einer Grundierungsschicht vorgesehen sein, um eine gute Haftung der Transferschicht 22 auf dem Silizium-Wafer 1 zu erhalten. Eine metallische Transferschicht kann dabei in einem der Verfahrensschritte galvanisch verstärkt werden, wie beispielsweise in EP 0 385 995 B1 beschrieben.

Die Trägerfolie kann beispielsweise aus Polyester mit einer Dicke von 19 µm bis 50 µm gebildet sein. In dem in Fig. 1a, b dargestellten Ausführungsbeispiel weist die Trägerfolie eine Stärke von etwa 23 µm auf. Die Ablöseschicht wird in diesem Ausführungsbeispiel nicht übertragen. Es kann aber auch vorgesehen sein, dass die Ablöseschicht zumindest teilweise übertragen wird und beispielsweise in einem nachfolgenden Sinterungsprozess in die Gasphase übertritt. In diesem Ausführungsbeispiel wurde keine Grundierungsschicht vorgesehen, die als Klebeschicht dient. Es kann aber auch vorgesehen sein, dass gleichzeitig mindestens eine Grundierungsschicht partiell oder vollflächig übertragen wird.

Die Herstellung der Heißprägefolie kann vorteilhafterweise in einem Rolle-zu-Rolle-Verfahren erfolgen. Dabei kann die Transferschicht in vielfältiger Weise modifiziert werden.

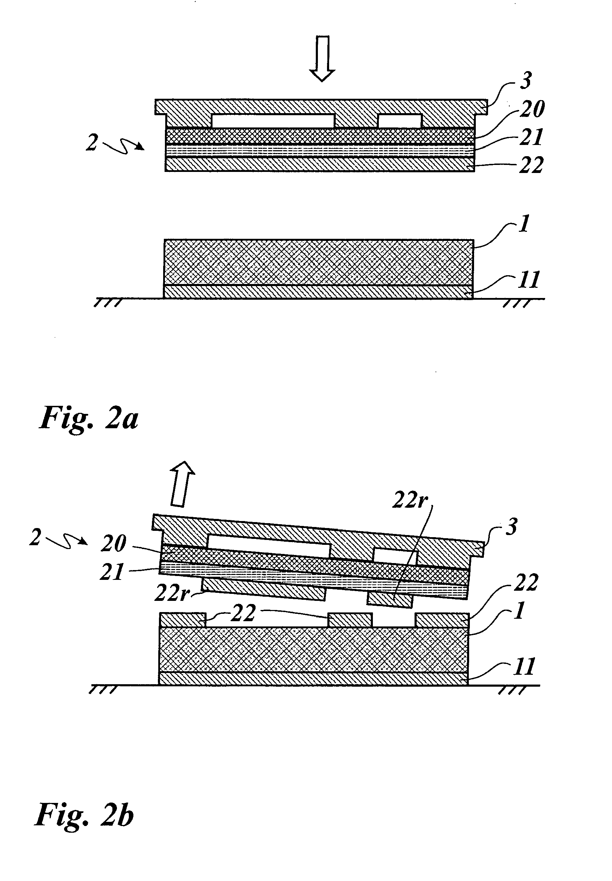

Die Fig. 2a, b zeigen nun ein zweites Ausführungsbeispiel, bei dem die Transferschicht 22 der Heißprägefolie 2 vollflächig ausgebildet ist (Fig. 2a) und wie in dem in den Fig. 1a, b dargestellten Ausführungsbeispiel keine Grundierungsschicht vorgesehen ist. Der Prägestempel 3 weist eine Oberflächenstruktur auf, die der zu übertragenden Leitungsstruktur entspricht, wobei die Bereiche zwischen den Leiterbahnen vertieft ausgebildet sind, so dass die Oberfläche des Prägestempels 3 nur in den Bereichen der Leiterbahnen in Kontakt mit der Heißprägefolie steht.

Wie in Fig. 2b dargestellt, werden bei dem Prägen von der Transferschicht 22 nur die Bereiche auf den Silizium-Wafer 1 übertragen, die auf den erhabenen Bereichen des Prägestempels 3 angeordnet sind. Beim Trennen des Prägestempels 3 von dem Silizium-Wafer 1 verbleiben diese Bereiche auf dem Silizium-Wafer 1. Über den vertieften Bereichen des Prägestempels 3 angeordnete Bereiche 22r der Transferschicht 22 verbleiben auf der Heißprägefolie 2 und werden mit dieser abgelöst.

Das in den Fig. 2a, b dargestellte Verfahren kann Vorteile für Versuchsdurchführungen und Kleinserien haben und vorteilhafterweise immer dann vorgesehen sein, wenn die Herstellungskosten des Prägestempels geringer sind als die Herstellungskosten einer mit einer strukturierten Transferschicht ausgebildeten Heißprägefolie. Es kann, wie weiter oben beschrieben, vorgesehen sein, dass die Ablöseschicht zumindest teilweise übertragen wird und beispielsweise in einem nachfolgenden Sinterungsprozess in die Gasphase übertritt. Es kann ferner wie weiter oben beschrieben vorgesehen sein, dass zusätzlich eine oder mehrere partielle oder vollflächige Grundierung(en) übertragen werden.

Bei den vorstehend beschriebenen Ausführungsbeispielen kann nach dem Übertragen der Transferschicht ein Sinterungsprozess vorgesehen sein, um die übertragene Transferschicht dauerhaft mit dem Silizium-Wafer 1 zu verbinden und einen guten elektrischen Kontakt auszubilden. Es kann beispielsweise vorgesehen sein, etwa 10 bis 30 Minuten zu sintern und dabei für etwa 5 Minuten eine Temperatur von etwa 500 °C zu halten. Hierbei werden organische Bestandteile der Transferschicht ausgetrieben und es wird z.B. eine metallische Elektrode erzeugt.

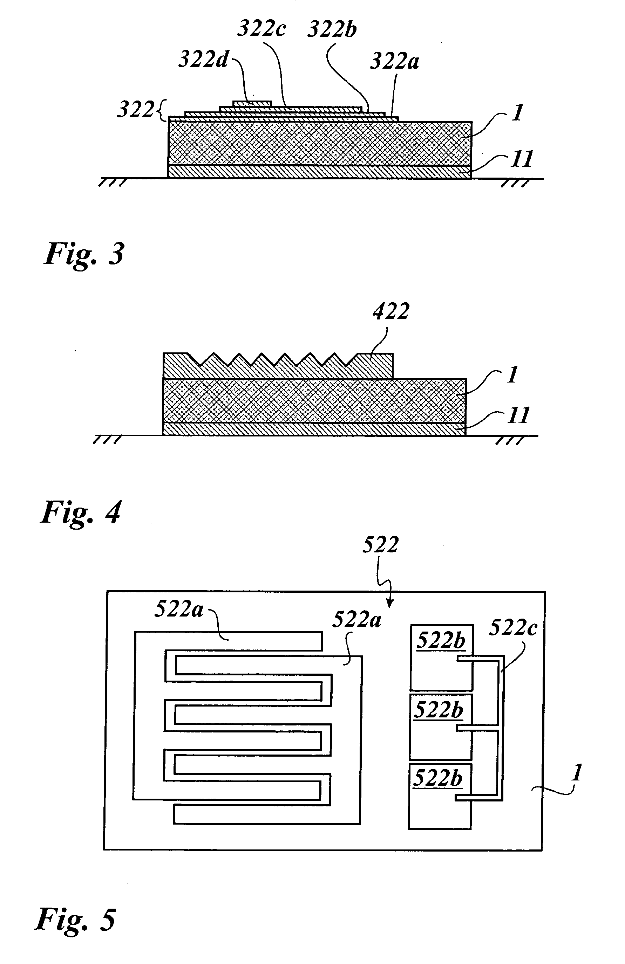

Fig. 3 zeigt nun ein drittes Ausführungsbeispiel, bei dem auf den Silizium-Wafer 1 eine aus vier Teiltransferschichten 322a bis 322d gebildete Transferschicht 322 übertragen ist. In dem in Fig. 3 dargestellten Ausführungsbeispiel sind die übertragenen Teiltransferschichten 322a bis 322d unterschiedlich strukturiert, so dass beispielsweise ein Leitfähigkeitsprofil in den Leiterbahnen bzw. Elektrodenbereichen ausgebildet sein kann.

Es kann aber auch vorgesehen sein, dass die Teiltransferschichten 322a bis 322d aus unterschiedlichem Material ausgebildet sind. Beispielsweise kann die oberste, außen liegende Teiltransferschicht 322d besonders witterungsbeständig ausgebildet sein, die innerste Teiltransferschicht 322a besonders haftfest ausgebildet sein und die beiden dazwischen angeordneten Teiltransferschichten 322b und 322c können über eine hohe Leitfähigkeit verfügen. In diesem Beispiel könnte die innerste Teiltransferschicht 322a oder der innere Schichtverbund beispielsweise Aluminium enthalten, die außen liegende Teiltransferschicht 322d oder der äußere Schichtverbund Chrom.

Nach jedem Schichtauftrag kann ein Sinterungsprozess vorgesehen sein, wobei weiter vorgesehen sein kann, die Sintertemperatur und die Sinterzeit für jeden Schichtauftrag zu variieren.

Fig. 4 zeigt ein viertes Ausführungsbeispiel, bei dem der Querschnitt einer Transferschicht 422 strukturiert ist. In dem in Fig. 4 dargestellten Ausführungsbeispiel ist die von dem Silizium-Wafer 1 abgewandte Seite der Transferschicht 422 mit einer sägezahnförmigen Oberflächenstruktur versehen.

Eine solche Strukturierung ist bei der vorgeschlagenen Verwendung einer Heißprägefolie passergenau möglich, beispielsweise über eine in die Heißprägefolie integrierte Replizierschicht, in welche das negative Oberflächenprofil abgeformt ist. Es kann auch vorgesehen sein, dass das negative Oberflächenprofil in die Trägerfolie 20 direkt abgeformt ist.

Fig. 5 zeigt nun ein fünftes Ausführungsbeispiel in der Draufsicht, das beispielhaft die Gestaltungsmöglichkeiten des erfindungsgemäßen Verfahrens aufzeigt.

Auf den Silizium-Wafer 1 sind nacheinander drei Teiltransferschichten 522a bis 522c übertragen, die Leiterbahnen 522 ergeben. Die Teiltransferschichten 522a und 522b liegen in dem in Fig. 5 dargestellten Ausführungsbeispiel in einer Ebene, ebenso die Bereiche der Teiltransferschicht 522c, die nicht Bereiche der Teiltransferschichten 522b überdecken. Bei den Teiltransferschichten 522b kann es sich beispielsweise um zweite Elektrodenschichten handeln, die den ersten Elektrodenschichten 11 gegenüberliegen. Bei der Teiltransferschicht 522c kann es sich um Leiterbahnen handeln, welche die Teiltransferschichten 522b elektrisch miteinander verbinden. Die Teiltransferschichten 522b und 522c können aus unterschiedlichem Material ausgebildet sein, so dass die Materialeigenschaften den Funktionen "Elektrode" und "Leitungsverbindung" optimal angepasst sein können.

Die Teiltransferschicht 522a kann beispielsweise einen Kondensator oder eine Antennenanordnung bilden, um eine Zusatzfunktion zu realisieren, etwa einen Kondensator oder eine Antenne für einen in den Silizium-Wafer integrierten RFID-Chip. Beispielsweise kann das Material und/oder die Querschnittsstruktur und/oder die Oberflächenstruktur der Teiltransferschicht 522a für diese Funktion optimiert sein. Eine vielfach gegliederte Oberflächenstruktur kann beispielsweise eine wesentlich größere Oberfläche als eine glatte Oberflächenstruktur aufweisen und deshalb für hohe Frequenzen eine bessere elektrische Leitfähigkeit aufweisen, d.h. hinsichtlich der Ausnutzung des sog. Skin-Effekts optimiert sein.

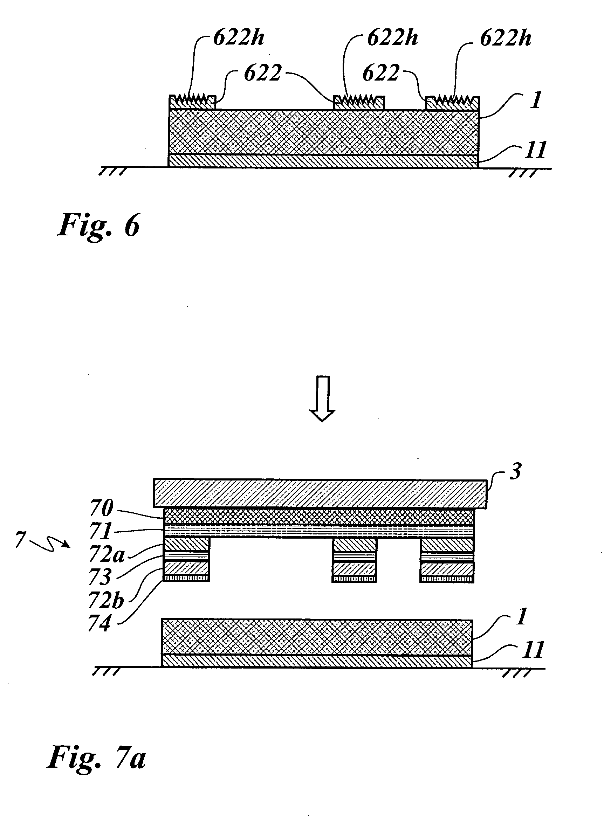

Fig. 6 zeigt nun ein weiteres Ausführungsbeispiel, bei dem auf dem Silizium-Wafer 1 mit rückseitiger erster Elektrodenschicht 11 vorderseitige Elektrodenschichten 622 aufgeprägt sind, die personalisiert sind. Die Personalisierung ist nach dem Übertragen der Elektrodenschicht durch Abprägen eines Oberflächenprofils, beispielsweise eines Hologramms, in die von dem Silizium-Wafer 1 abgewandte Oberfläche der Elektrodenschicht 622 vorgenommen worden. Die Personalisierung kann beispielsweise vorgesehen sein, um ein fälschungssicheres Echtheitszertifikat aufzubringen.

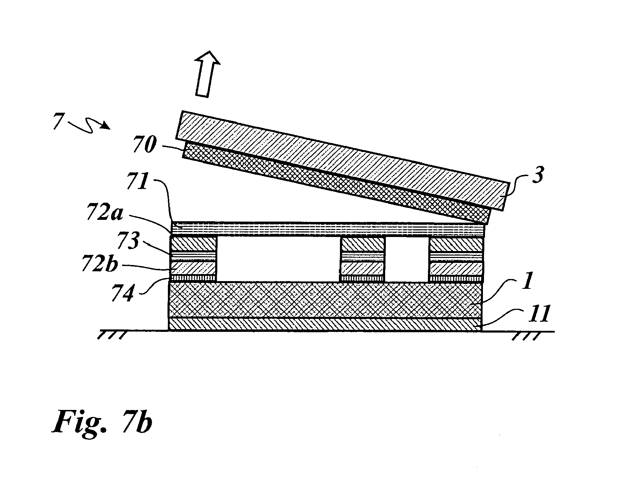

Die Fig. 7a und 7b zeigen nun Verfahrensschritte zum Aufbau von mehrschichtigen zweiten Elektrodenschichten.

Fig. 7a zeigt eine Heissprägefolie 7, die mit dem Prägestrempel 3 auf den Silizium-Wafer 1 gepresst wird. Die Heissprägefolie 7 ist aus einer Trägerfolie 70, einer Ablöseseschicht 71, einer ersten elektrisch leitfähigen Transferschicht 72a, einer Zwischenschicht 73, einer zweiten elektrisch leitfähigen Transferschicht 72b und einer Grundierungsschicht 74 gebildet.

Beim Heissprägen werden die beiden Transferschichten 72a, 72b gemeinsam übertragen, wie in Fig. 7b dargestellt, wobei nach der Übertragung wiederum ein Sinterprozess vorgesehen ist, der die beiden Transferschichten sowohl untereinander als auch mit der Oberfläche des Silizium-Wafers 1 verbindet.

Die Ablöseschicht 71 ist so eingestellt, dass sie nicht auf der Heißprägefolie 7, sondern auf der Elektrodenschicht verbleibt. Die Ablöseschicht 71 wird deshalb erst im Sinterungsschritt entfernt.

## Patentansprüche

1. Verfahren zur Erzeugung von Leiterbahnen (322, 422, 522) auf einem für photovoltaische Zellen vorgesehenen Silizium-Wafer (1),
**dadurch gekennzeichnet,**
**dass** mindestens eine elektrisch leitfähige Transferschicht (22) von einer Prägefolie (2), insbesondere einer Heißprägefolie, vollständig oder bereichsweise auf die Oberfläche des Silizium-Wafers (1) übertragen wird.

2. Verfahren nach Anspruch 1,
**dadurch gekennzeichnet,**
**dass** eine Prägefolie (2) mit einer geometrisch strukturierten elektrisch leitfähigen Transferschicht (22) verwendet wird.

3. Verfahren nach Anspruch 1,
**dadurch gekennzeichnet,**
**dass** eine Prägefolie (2) mit einer vollflächigen elektrisch leitfähigen Transferschicht (22) verwendet wird, und dass die Transferschicht (22) bei der Übertragung auf den Silizium-Wafer (1) durch einen Strukturstempel (3) strukturiert wird.

4. Verfahren nach einem der vorangehenden Ansprüche,
**dadurch gekennzeichnet,**
**dass** die Leiterbahnen (322, 522) in mehr als einem Prägeschritt erzeugt werden.

5. Verfahren nach Anspruch 4,
**dadurch gekennzeichnet,**
**dass** nacheinander Transferschichten aus unterschiedlichem Material und/oder mit unterschiedlicher elektrischer Leitfähigkeit und/oder mit unterschiedlicher geometrischer Struktur und/oder mit unterschiedlicher Querschnittsprofil übertragen werden.

6. Verfahren nach Anspruch 5,
**dadurch gekennzeichnet,**
**dass** durch Übertragen von zwei oder mehr Transferschichten in der Leiterbahn ein Leitfähigkeitsgradient erzeugt wird.

7. Verfahren nach einem der vorangehenden Ansprüche,
**dadurch gekennzeichnet,**
**dass** die geometrische Struktur und/oder eine Leitfähigkeitsstruktur der Leiterbahn (322, 422, 522) durch die Ausbildung des Prägestempels (3) und/oder der Prägefolie (2) eingestellt wird bzw. werden.

8. Verfahren nach einem der Ansprüche 4 bis 7,
**dadurch gekennzeichnet,**
**dass** Prägefolien (2) mit Trägerschichten (20) verwendet werden, die sich mindestens in einer Eigenschaft voneinander unterscheiden, beispielsweise Dicke und/oder Flexibilität und/oder stoffliche Zusammensetzung.

9. Verfahren nach einem der vorangehenden Ansprüche,
**dadurch gekennzeichnet,**
**dass** nach dem Übertragen der Transferschicht (22) bzw. der Transferschichten ein Sinterungsprozess ausgeführt wird, wobei die Sinterungstemperatur insbesondere im Bereich von 300 °C bis 800 °C, bevorzugt im Bereich von 450 °C bis 550 °C eingestellt wird.

10. Verfahren nach einem der vorangehenden Ansprüche,
**dadurch gekennzeichnet,**
**dass** eine Transferschicht als Abschlussschicht aufgebracht wird, die ein optisch variables Element aufweist.

11. Prägefolie, insbesondere Heißprägefolie, zur Durchführung des Verfahrens nach einem der Ansprüche 1 bis 16,
**dadurch gekennzeichnet,**
**dass** die Prägefolie (2) eine strukturierte elektrisch leitfähige Transferschicht (22) aufweist, die insbesondere geometrisch und/oder in ihrem Querschnitt strukturiert ist.

12. Prägefolie nach einem der Ansprüche 17 bis 19,
**dadurch gekennzeichnet,**
**dass** die Transferschicht (22) als Metallschicht, insbesondere enthaltend Metallpartikel, aus Kohlenstoff-Nanotubes und/oder aus elektrisch leitfähigen Polymeren gebildet ist.

13. Prägefolie nach einem der Ansprüche 17 bis 22,
**dadurch gekennzeichnet,**
**dass** die Prägefolie (2) eine oder mehrere Ablöseschichten (21) aufweist.

14. Prägefolie nach einem der Ansprüche 17 bis 23,
**dadurch gekennzeichnet,**
**dass** die Prägefolie (2) eine oder mehrere Grundierungsschichten aufweist.

15. Photovoltaische Zelle auf der Basis eines Silizium-Wafers, auf dessen Oberfläche eine elektrisch leitfähige strukturierte Transferschicht einer Prägefolie, insbesondere nach einem der Ansprüche 11 bis 14, appliziert ist.
